# EUROPÄISCHE PATENTSCHRIFT

(11) **EP 3 305 044 B1**
(45) Veröffentlichungstag und Bekanntmachung des Hinweises auf die Patenterteilung: **12.01.2022**
(21) Anmeldenummer: 16720094.8
(22) Anmeldetag: 27.04.2016
(51) Int. Cl.: H05K 5/00, H05K 7/20, B29C 35/08, B29C 33/06

(54) **WERKZEUG UND VERFAHREN ZUM ERZEUGEN EINER ELEKTRONISCHEN VORRICHTUNG**
TOOL AND METHOD FOR PRODUCING AN ELECTRONIC DEVICE
OUTIL ET PROCÉDÉ POUR PRODUIRE UN DISPOSITIF ÉLECTRONIQUE

(30) Priorität: 26.05.2015 DE 102015209585
(43) Veröffentlichungstag der Anmeldung: 11.04.2018
(73) Patentinhaber: Robert Bosch GmbH, 70442 Stuttgart (DE)
(72) Erfinder: GEISE, Stephan, 59602 Ruethen (DE)
(86) Internationale Anmeldenummer: PCT/EP2016/059350
(87) Internationale Veröffentlichungsnummer: WO 2016/188698

(56) Entgegenhaltungen:
- WO-A1-2013/186185
- DE-A1- 19 753 863
- DE-A1-102009 005 067
- DE-A1-102010 002 141
- DE-A1-102010 030 170
- DE-A1-102013 208 543
- US-A1- 2014 002 998
- US-A1- 2015 091 218

## Beschreibung

### Stand der Technik

Die Erfindung betrifft eine elektronische Vorrichtung, insbesondere ein Steuergerät für ein Kraftfahrzeug, Elektrofahrzeug oder Hybridfahrzeug. Die Vorrichtung weist ein Gehäuse auf, wobei das Gehäuse einen Hohlraum umschließt. Die Vorrichtung weist auch einen in dem Hohlraum angeordneten Schaltungsträger auf, wobei der Schaltungsträger wenigstens einen Halbleiterbaustein aufweist. Die Vorrichtung weist eine Wärmesenke auf, welche mit dem Halbleiterbaustein wärmeleitend verbunden ist, wobei das Gehäuse ein Kunststoffgehäuse ist und eine Gehäusewand aufweist. In der Gehäusewand sind wenigstens zwei zueinander benachbarte Wandbereiche ausgebildet, wobei die Wärmesenke als ein wärmeleitfähiger Wandbereich der Wandbereiche des Gehäuses ausgebildet ist, wobei wenigstens ein weiterer Wandbereich der Wandbereiche eine zu dem wärmeleitfähigen Wandbereich kleinere Wärmeleitfähigkeit aufweist.

Aus der DE 10 2009 005 067 A1 ist ein Gehäusedeckel für ein Gehäuse bekannt, welcher durch eine wärmeleitfähige Platte gebildet ist. An der Platte sind zwei zueinander verschiedene Wandbereiche ausgebildet, wobei ein Wandbereich der Wandbereiche eine größere Wärmeleitfähigkeit aufweist als ein zweiter Wandbereich. Die Wärmeleitfähigkeit des ersten Wandbereichs kann durch einen Kunststoff mit Kohlenstoff-Zusatzpartikeln gebildet sein.

Aus der DE 197 53 863 A1 ist eine Vorrichtung und ein Verfahren zur Herstellung einer Zylinderkopfdichtung bekannt, wobei Werkzeughälften eines Spritzgusswerkzeugs für UV-Strahlen transparent sind und eine UV-Strahlenquelle aufweisen.

Aus der WO 2013/186185 ist ein Verfahren zur Herstellung von Kunststoff-Formkörpern bekannt, bei dem Hart-Weich-Formteile aus niedrigschmelzenden thermoplastischen Kunststoffen und einer lichthärtenden Polyorganosiloxan-Zusammensetzung hergestellt werden.

Aus der Offenlegungsschrift DE102010002141 A1 ist eine Werkzeuganordnung bekannt, mittels welcher lichthärtende Polymerzusammensetzung unter Aussetzung von UV-Strahlen gehärtet werden.

Offenbarung der Erfindung Erfindungsgemäß ist der wärmeleitfähige Wandbereich durch einen partikelgefüllten Duroplast gebildet, welcher mittels elektromagnetischer Strahlen, insbesondere Ultraviolett-Strahlen auspolymerisiert ist. Dadurch kann der wärmeleitfähige Wandbereich vorteilhaft eine hohe Steifigkeit aufweisen, sodass ein Leistungshalbleiter, insbesondere Leistungshalbleiterbaustein, an dem wärmeleitfähigen Wandbereich gut ankoppeln kann. Weiter vorteilhaft lässt sich der Duroplast als wärmeleitfähiger Wandbereich bei einer niedrigen Temperatur als niedrigviskoses, flüssiges Material in eine Spritzform einspritzen, in der der dazu benachbarte Wandbereich bereits auspolymerisiert vorliegt. Vorteilhaft kann das so in ein Werkzeug eingespritzte Duroplastmaterial, insbesondere ein Monomer zum Erzeugen eines Duroplast, mit einem als zu dem wärmeleitfähigen Wandbereich benachbarten Wandbereich gebildeten Thermoplast sicher verbunden, insbesondere verzahnend verbunden werden.

In einer bevorzugten Ausführungsform weist das Gehäuse einen Gehäusedeckel auf, wobei der wärmeleitfähige Wandbereich in dem Gehäusedeckel ausgebildet ist. So kann der Gehäusedeckel vorteilhaft mit dem wärmeleitfähigen Wandbereich auf einen in dem Gehäuse aufgenommenen, beispielsweise mit einem Schaltungsträger verbundenen Halbleiterbaustein aufgesetzt werden, um so den Halbleiterbaustein wärmeleitend zu kontaktieren.

Der wärmeleitfähig ausgebildete Wandbereich ist bevorzugt durch einen mittels elektromagnetischer Strahlen, insbesondere Ultraviolett-Strahlen aushärtbar ausgebildeten Duroplast, insbesondere Duroplast-Monomer gebildet. Der Duroplast ist bevorzugt durch ein Harz, insbesondere Epoxidharz, Polyesterharz oder durch einen Acrylharz, insbesondere Acrylat, gebildet.

Erfindungsgemäß ist der wärmeleitfähige Wandbereich durch einen partikelgefüllten Duroplast gebildet.

Die Partikel sind beispielsweise Keramikpartikel, insbesondere aus Siliziumoxid, Bornitrid oder Aluminiumoxid oder einer Kombination aus diesen. In einer anderen Ausführungsform sind die Partikel Kohlenstoffpartikel, insbesondere Kohlenstoff-Nanopartikel. Der Partikelanteil im Duroplast beträgt bevorzugt zwischen 50 und 80 Gewichts-Prozent, weiter bevorzugt 80 Gewichts-Prozent des Wärmeleitfähigen Wandbereichs, der Rest ist durch den Duroplast als Matrixmaterial gebildet.

Vorteilhaft kann der Duroplast, insbesondere ein Monomer zum Ausbilden des Duroplasts, nach einem Einspritzen in das Werkzeug mit dem weiteren Wandbereich verzahnend, bevorzugt unter Ausbildung eines Formschlusses, verbunden werden und nach dem Einspritzen mit UV-Strahlen ausgehärtet werden. So kann vorteilhaft auf dem zuvor mittels Spritzgusstechnik erzeugten thermoplastischen Wandbereich keine Temperaturverformung mehr beim Erzeugen des wärmeleitfähigen Wandbereichs in dem weiteren Wandbereich einwirken.

Zur Ausbildung der Erfindung eignet sich ein Werkzeug zum Erzeugen eines Gehäuseteils aus Kunststoff, insbesondere eines Gehäuses der vorbeschriebenen Art. Das Werkzeug weist wenigstens eine erste Werkzeughälfte und wenigstens eine zweite Werkzeughälfte auf. Die Werkzeughälften umschließen gemeinsam einen Hohlraum, welcher ausgebildet ist, mit Kunststoff-Ausgangsstoff, insbesondere Kunststoffmonomer gefüllt zu werden, wobei der Hohlraum einer Form des Gehäuseteils, insbesondere Gehäusedeckel entspricht.

Beispielsweise weist die erste Werkzeughälfte, oder die zweite Werkzeughälfte, oder beide Werkzeughälften, wenigstens einen dem Hohlraum zugewandten Teilbereich auf, wobei der Teilbereich für Ultraviolett-Strahlen transluzent ausgebildet ist. Beispielsweise weist das Werkzeug eine Ultraviolett-Strahlenquelle auf, welche ausgebildet und angeordnet ist, durch den Teilbereich Ultraviolett-Strahlen hindurch in den Hohlraum zu senden. So kann der wärmeleitfähige Wandbereich noch sich in dem Werkzeug befindend, mittels der UV-Strahlen schnell ausgehärtet werden. So kann mittels des so ausgebildeten Werkzeugs eine schnelle Zykluszeit zum Erzeugen eines Gehäusedeckels mit dem wärmeleitfähigen Wandbereich erzielt werden.

Beispielsweise ist die Ultraviolett-Strahlenquelle in dem Teilbereich angeordnet, weiter beispielhaft in dem Teilbereich eingebettet. Die Ultraviolett-Strahlen können so den Teilbereich sicher durchfluten, und so gleichmäßig in den Hohlraum mit einer gleichmäßigen, über den Teilbereich verteilten Strahlendichte eindringen.

Beispielsweise ist die Ultraviolett-Strahlenquelle durch wenigstens eine Lumineszenzdiode oder durch eine Gasentladungslampe gebildet. Beispielsweise ist die Gasentladungslampe ausgebildet, Ultraviolett-Strahlen mit der Wellenlänge 254 Nanometer auszusenden. Die Lumineszenzdiode ist beispielsweise ausgebildet, Ultraviolett-Strahlen im Bereich zwischen 200 und 300 Nanometern zu erzeugen.

Beispielsweise ist der Teilbereich des Werkzeugs durch ein Glas, insbesondere Quarzglas, gebildet. So kann das Werkzeug vorteilhaft eine sichere Kontur zum Ausspritzen des wärmeleitfähigen Wandbereichs bilden.

Beispielsweise sind Teile des Werkzeugs, insbesondere die zweite Werkzeughälfte, welche ausgebildet sind, den wärmeleitfähigen Wandbereich zu formen, wenigstens an einer Oberfläche oder massiv aus Chromstahl gebildet. Dadurch lässt sich der Duroplast leicht entformen, da das Duroplastmaterial an dem Chrom oder Chromstahl nicht anhaften kann.

Der Teilbereich des Werkzeugs kann beispielsweise auch durch einen Silikon-Kunststoff oder Silikon-Gummi, oder einen transparenten Thermoplast gebildet. Der wärmeleitfähige Wandbereich als auspolymerisierter Duroplast kann so leicht aus dem Werkzeug entfernt werden.

Beispielsweise ist der Teilbereich des Werkzeugs durch einen für UV-Strahlen transluzent ausgebildeten Kunststoff gebildet. Der Kunststoff ist beispielsweise ein Epoxidharz, Polyacrylat, insbesondere PMMA (PMMA = Poly-Methyl-MethAcrylat), oder ein silikonhaltiger Kunststoff oder Silikon-Gummi.

Zur Ausbildung der Erfindung kann ein Verfahren zum Erzeugen eines Kunststoffgehäuseteils zur Anwendung kommen. Das Gehäuseteil weist eine Gehäusewand auf, wobei in der Gehäusewand wenigstens ein wärmeleitfähiger Wandbereich ausgebildet ist, welcher aus einem Kunststoff gebildet ist, welcher eine größere Wärmeleitfähigkeit aufweist als der den Wandbereich umgebende Wandbereich, insbesondere Kunststoff des Gehäuseteils.

Das Verfahren umfasst beispielsweise die Schritte:
- Einspritzen eines mittels UV-Strahlen aushärtbaren Kunststoffmonomers, insbesondere Duroplast bildenden Monomers in den Hohlraum;
- Aushärten des Kunststoffmonomers zum Ausbilden eines Duroplasts mittels UV-Strahlen, wobei die UV-Strahlen von dem Werkzeug ausgehend in den Hohlraum gesendet werden. Das Werkzeug kann so beim Aushärten des Duroplastmaterials verschlossen bleiben.

Bevorzugt wird das Kunststoffmonomers zum Ausbilden eines Duroplasts an einen als Thermoplast ausgebildeten den Wandbereich umgebenden Wandbereich angespritzt, so dass die Wandbereiche miteinander, insbesondere aneinander formend oder formschlüssig ineinander formend, verbunden sind.

In einer bekannten Ausführungsform werden die UV-Strahlen durch einen Teilbereich des Werkzeugs, insbesondere eines Teilbereichs einer Werkzeughälfte, in den Hohlraum gesendet. Dadurch kann der übrige Teil des Werkzeugs, den Teilbereich ausgenommen, aus einem aufwandsgünstig bereitzustellenden Werkzeugmaterial, beispielsweise Stahl, ausgebildet sein.

Beispielsweise ist die UV-Strahlenquelle in dem Teilbereich des Werkzeugs, insbesondere der Werkzeughälfte, angeordnet. Dadurch kann der Teilbereich effizient durchstrahlt werden. Ferner kann die Strahlenquelle so platzsparend in dem Teilbereich aufgenommen sein.

Bevorzugt ist der mittels UV-Strahlen aushärtbar ausgebildete Kunststoff Epoxidharz, Polyacrylat, insbesondere PMMA, oder Polyesterharz. Dadurch kann ein kurzer Herstellungszyklus zur Deckelherstellung erreicht werden.

Die Erfindung wird nun im Folgenden anhand von weiteren Ausführungsbeispielen und Figuren beschrieben. Weitere vorteilhafte Ausführungsvarianten ergeben sich aus den in den abhängigen Ansprüchen und in den Figuren beschriebenen Merkmalen.
Figur 1 zeigt ein zur Ausbildung der Erfindung verwendbares Werkzeug zum Erzeugen eines Gehäusedeckels mit einem wärmeleitfähigen Wandbereich, bei dem das Werkzeug mit einer thermoplastischen Kunststoffkomponente zum Erzeugen eines Gehäusedeckelrandes gefüllt wird;
Figur 2 zeigt das in Figur 1 dargestellte Werkzeug, bei dem ein duroplastischer Kunststoff zum Ausbilden des wärmeleitfähigen Wandbereichs in das Werkzeug eingespritzt wird;
Figur 3 zeigt ein Ausführungsbeispiel für eine elektronische Vorrichtung mit einem einen Hohlraum umschließenden Gehäuse umfassend einen Gehäusebecher und einen Gehäusedeckel, und einem Schaltungsträger, der in dem Hohlraum aufgenommen ist, wobei ein mit dem Schaltungsträger verbundener Halbleiterbaustein an den Gehäusedeckel wärmeleitfähig angekoppelt ist.

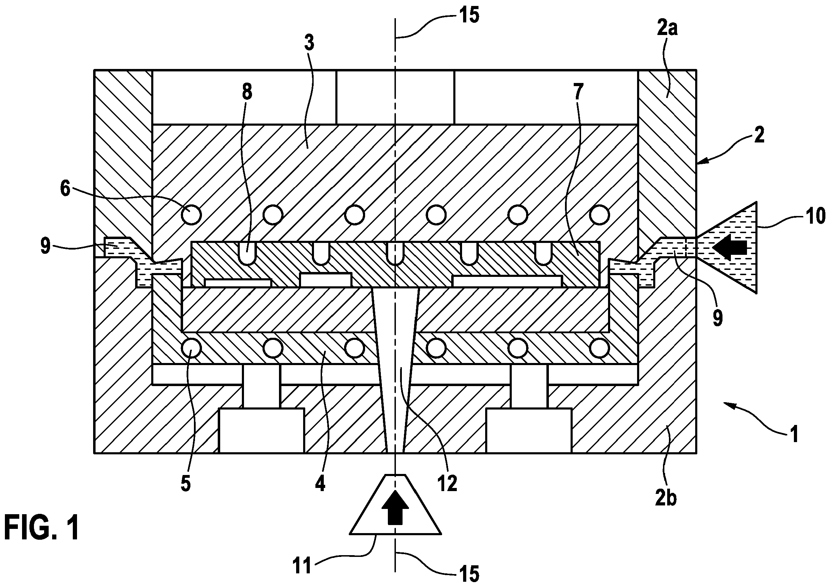

Figur 1 zeigt ein zur Ausbildung der Erfindung verwendbares Werkzeug 1 zum Erzeugen eines Gehäuses für eine elektronische Vorrichtung. Das Werkzeug 1 weist einen Rahmen 2 auf, in dem eine Werkzeughälfte 3 und eine Werkzeughälfte 4 - nach Art eines Schlittens - hin- und herbeweglich geführt sind.

Die Werkzeughälfte 3 bildet in diesem Ausführungsbeispiel einen Stempel, insbesondere Auswerferstempel, zum Erzeugen eines Gehäusedeckels für das Gehäuse. Die Werkzeughälfte 4 bildet einen Kernzug zum Erzeugen des Gehäusedeckels. Die Werkzeughälfte 3 weist einen zum Fluidführen ausgebildeten Hohlraum 6 auf, über den die Werkzeughälfte 3 mittels einer in dem Hohlraum 6 fließenden Flüssigkeit temperiert, insbesondere erwärmt, werden kann. Die Werkzeughälfte 4 weist einen Hohlraum 5 auf, über den die Werkzeughälfte 4 mittels einer Heizflüssigkeit temperiert werden kann. Die Heizflüssigkeit ist beispielsweise Öl oder Wasser.

Zum Erzeugen eines Gehäusedeckels für die vorab beschriebene elektronische Vorrichtung kann der Gehäusedeckel mittels der im Folgenden beschriebenen Verfahrensschritte erzeugt werden:
Die Werkzeughälften 3 und 4 können innerhalb des Rahmens 2 aufeinanderzubewegt werden, sodass zwischen den Werkzeughälften ein umlaufend ausgebildeter Hohlraum 14 zum Erzeugen eines Gehäusedeckelrandes, insbesondere eines Hinterschnittbereiches des Gehäusedeckelrandes, gebildet ist. Der Rahmen 2 ist in diesem Ausführungsbeispiel trennbar ausgebildet, sodass der Rahmen 2 in eine Rahmenhälfte 2a und in eine Rahmenhälfte 2b geteilt werden kann. Zwischen den Rahmenhälften 2a und 2b ist ein an den Hohlraum 14 angeformter Hohlraum 9 zum Ausbilden eines Teils des Gehäusedeckelrandes ausgebildet. Der Hohlraum 9 steht mit dem Hohlraum 14 in Verbindung.

In einem ersten Schritt zum Erzeugen des Gehäusedeckels kann mittels einer Spritzeinheit 10 eine Spritzgusskomponente, insbesondere eine Komponente zum Erzeugen eines thermoplastisch ausgebildeten Kunststoffs, beispielsweise Polyamid, insbesondere ein lasertransparenter Polyamid, eingespritzt werden. Das Polyamid kann als thermoplastisch ausgebildete Spritzgusskomponente die Hohlräume 9 und 14 ausfüllen.

In einem weiteren Schritt zum Erzeugen des Gehäusedeckels können die Werkzeughälften 3 und 4 auseinandergefahren werden, sodass ein Hohlraum 13 gebildet ist. Der zuvor beim Erzeugen des Randes mittels der Spritzeinheit 10 erzeugte Teil des Randes, welcher in dem Hohlraum 14 ausgebildet ist, kann in den so nach dem Auseinanderfahren der Werkzeughälften 3 und 4 gebildeten Hohlraum 13 hineinragen. Der Teil des Randes des Gehäusedeckels, welcher sich in dem Hohlraum 9 erstreckt, kann zwischen den Rahmenhälften 2a und 2b des Rahmens 2 festgehalten werden.

Der Hohlraum 13 schließt in diesem Ausführungsbeispiel an einen Hohlraum 12 zum Einspritzen einer weiteren Kunststoffkomponente in den Hohlraum 13 an. Eine weitere Spritzgusseinheit 11 kann nun über den Hohlraum 12 ein insbesondere dünnflüssiges Monomer zum Erzeugen eines Duroplasts über den Hohlraum 12 in den Hohlraum 13 einspritzen, und so den Hohlraum 13 ausfüllen.

Die Werkzeughälfte 3 weist beispielsweise einen für Ultraviolett-Strahlen 25 transluzenten Teilbereich 7 auf, welcher beispielsweise durch Glas, insbesondere Quarzglas, gebildet ist. Der Teilbereich 7 kann in einer anderen Ausführungsform durch einen Silikon-Gummi gebildet sein.

Die Werkzeughälfte 3 weist beispielsweise auch eine Strahlenquelle 8 zum Erzeugen von elektromagnetischen Ultraviolett-Strahlen 25 auf. Die Strahlenquelle 8 ragt in den Teilbereich 7 hinein und kann so den Teilbereich 7 derart ausstrahlen, dass die Ultraviolett-Strahlen 25 aus dem Teilbereich 7 in den Hohlraum 13 einstrahlen können.

Nach dem Einspritzen des zuvor erwähnten Kunststoffmonomers zum Erzeugen des duroplastischen wärmeleitfähigen Wandbereichs kann die Strahlenquelle 8 in einem weiteren Schritt aktiviert werden, und so Ultraviolett-Strahlen erzeugen, und diese durch den transluzenten Teilbereich 7 hindurch in den Hohlraum 13 senden, in dem das Monomer zum Erzeugen des Duroplasts eingespritzt ist. Das Monomer kann so, angeregt durch die UV-Strahlen 25, welche durch die Strahlenquelle 8 erzeugt wurden, mittels Polykondensation vernetzen, und so einen duroplastischen Kunststoff ausbilden.

Der in dem Hohlraum 13 erzeugte wärmeleitfähige Wandbereich, gebildet durch den Duroplasten, kann den in dem Hohlraum 14 erzeugten Teil des thermoplastisch ausgebildeten Deckelrandes formschlüssig umgreifen. So kann eine Art Verzahnung gebildet sein, sodass der thermoplastisch ausgebildeten Deckelrand mit dem duroplastisch ausgebildeten wärmeleitfähigen Wandbereich des Gehäusedeckels fest verbunden ist.

Der Rahmen 2 des Werkzeugs 1 kann nun getrennt werden, indem die Rahmenhälften 2a und 2b - wie auch die Werkzeughälften 3 und 4 - entlang einer Längsachse 15 voneinander getrennt werden. Der sich in dem Hohlraum 12 erstreckende Teil des duroplastisch ausgebildeten wärmeleitfähigen Wandbereichs des Gehäusedeckels kann in einem anschließenden Schritt als Anguss abgetrennt werden.

Der wärmeleitfähige Wandbereich des Gehäusedeckels kann zum Erzeugen einer elektronischen Vorrichtung mit dem Gehäuse einen Gehäusebecher verschließen, wobei der thermoplastisch ausgebildete Deckelrand, welcher in dem Hohlraum 9 des Werkzeugs 1 erzeugt worden ist, mittels eines Lasers mit einem Rand eines Gehäusebechers verschweißt werden kann. Beim Verschließen des Gehäusebechers mittels des Gehäusedeckels kann der in dem Hohlraum 13 erzeugte wärmeleitfähige Wandbereich, insbesondere mittels in einer beispielhaft dargestellten Aussparung 16 erzeugten Vorsprungsbereiches - einen Leistungshalbleiter kontaktieren, sodass Verlustwärme von dem Leistungshalbleiter beim Betrieb der elektronischen Vorrichtung über den in dem Hohlraum 16 erzeugten Vorsprungsbereich an den wärmeleitfähigen Wandbereich, erzeugt in dem Hohlraum 13, abgegeben werden kann.

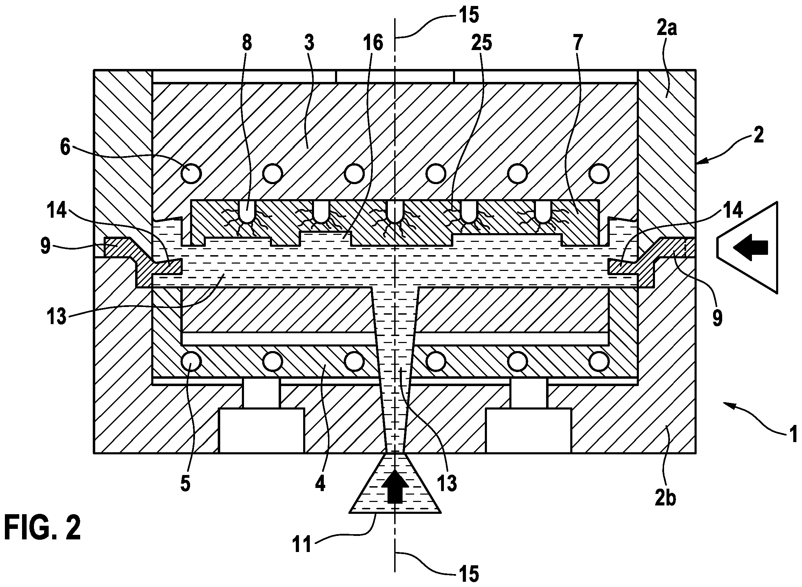

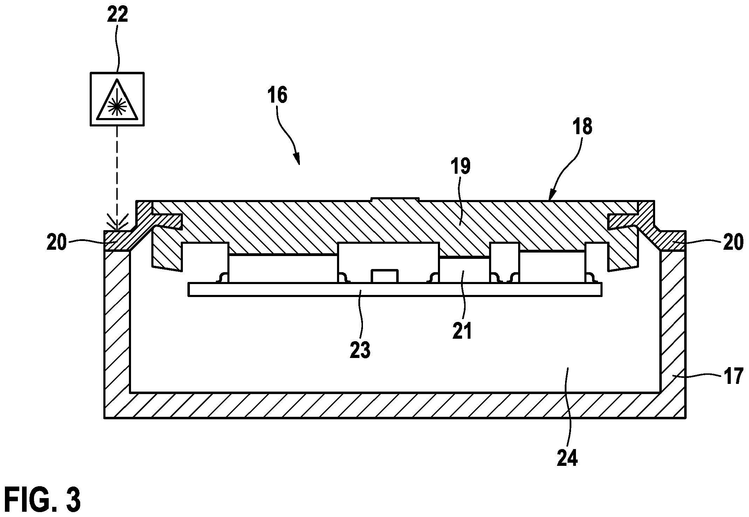

Figur 3 zeigt ein Ausführungsbeispiel für eine elektronische Vorrichtung 16 mit einem Schaltungsträger 23, einem einen Hohlraum 24 umschließenden Gehäuse umfassend einen Gehäusebecher 17 und einen Gehäusedeckel 18. Der Gehäusedeckel 18 weist einen in dem in Figur 2 dargestellten Hohlraum 13 erzeugten wärmeleitfähigen Wandbereich 19 auf.

Der Wandbereich 19 ist mit einem thermoplastisch ausgebildeten Deckelrand 20, mit einer wie in Figur 2 beschriebenen Verzahnung, erzeugt in dem Hohlraum 14, verbunden. Der Gehäusedeckel 18 kann auf einen in dem Gehäusebecher 17 aufgenommenen Schaltungsträger 23 mit einem Halbleiterbaustein 21 aufgesetzt werden, und den Halbleiterbaustein 21 mir einem in der Aussparung 16 erzeugten Vorsprung wärmeleitfähig kontaktieren. Der Deckelrand 20 des Gehäusedeckels 18 kann dann mit dem Gehäusebecher 17 mittels eines Lasers 22 verschweißt werden. Der Deckelrand 20 ist dazu durch einen laserverschweißbar ausgebildeten Thermoplast, beispielsweise Polyamid PA 66 gebildet. Von dem Halbleiterbaustein 21 erzeugte Verlustwärme kann über den wärmeleitfähigen Wandbereich 19 des Gehäusedeckels 18 an eine Umgebungsluft abgeführt werden. Der Halbleiterbaustein 21 ist beispielsweise ein Mikroprozessor oder ein Leistungshalbleiter, beispielsweise Halbleiterschalter. Der Halbleiterschalter ist beispielsweise ein Insulated-Gate-Bipolar-Transistor oder ein Feldeffekttransistor.

## Patentansprüche

1. Elektronische Vorrichtung (16), insbesondere Steuergerät, mit einem Gehäuse (17, 18), wobei das Gehäuse (17, 18) einen Hohlraum (24) umschließt und die Vorrichtung (16) einen in dem Hohlraum (24) angeordneten Schaltungsträger (23) aufweist, wobei der Schaltungsträger (23) wenigstens einen Halbleiterbaustein (21) aufweist, wobei die Vorrichtung (16) eine Wärmesenke (19) aufweist, welche mit dem Halbleiterbaustein (21) wärmeleitend verbunden ist, wobei das Gehäuse (17, 24) ein Kunststoffgehäuse ist und eine Gehäusewand (18) aufweist, wobei in der Gehäusewand (18) wenigstens zwei zueinander benachbarte Wandbereiche (19, 20) ausgebildet sind, und die Wärmesenke (19) als ein wärmeleitfähiger Wandbereich (19) der Wandbereiche (19, 20) des Gehäuses ausgebildet ist, und wenigstens ein weiterer Wandbereich (20) der Wandbereiche (19, 20) eine zu dem wärmeleitfähigen Wandbereich (19) kleinere Wärmeleitfähigkeit aufweist,
**dadurch gekennzeichnet, dass**
der wärmeleitfähige Wandbereich (19) durch einen partikelgefüllten Duroplast gebildet ist, welcher mittels Ultraviolett-Strahlen (25) auspolymerisiert ist.

2. Elektronische Vorrichtung (16) nach Anspruch 1,
**dadurch gekennzeichnet, dass**
die Partikel Keramikpartikel sind.

3. Elektronische Vorrichtung (16) nach Anspruch 2,
**dadurch gekennzeichnet, dass**
die Keramikpartikel aus Siliziumoxid, Bornitrid oder Aluminiumoxid oder einer Kombination aus diesen gebildet sind.

4. Elektronische Vorrichtung (16) nach Anspruch 2,
**dadurch gekennzeichnet, dass**
die Keramikpartikel aus Kohlenstoffpartikel, insbesondere Kohlenstoff-Nanopartikel, gebildet sind.

5. Elektronische Vorrichtung (16) nach einem der vorhergehenden Ansprüche,
**dadurch gekennzeichnet, dass**
der Partikelanteil im Duroplast zwischen 50 und 80 Gewichts-Prozent des Wärmeleitfähigen Wandbereichs beträgt, wobei der partikelfreie Rest durch den Duroplast als Matrixmaterial gebildet ist.

## Claims

1. Electronic device (16), in particular control unit, comprising a housing (17, 18), wherein the housing (17, 18) encloses a cavity (24) and the device (16) has a circuit carrier (23) arranged in the cavity (24), wherein the circuit carrier (23) has at least one semiconductor component (21), wherein the device (16) has a heat sink (19), which is thermally conductively connected to the semiconductor component (21), wherein the housing (17, 24) is a plastic housing and has a housing wall (18), wherein at least two wall regions (19, 20) adjacent to one another are embodied in the housing wall (18), and the heat sink (19) is embodied as a thermally conductive wall region (19) of the wall regions (19, 20) of the housing, and at least one further wall region (20) of the wall regions (19, 20) has a lower thermal conductivity than the thermally conductive wall region (19),
**characterized in that**
the thermally conductive wall region (19) is formed by a particle-filled thermosetting plastic that is polymerized to completion by means of ultraviolet rays (25) .

2. Electronic device (16) according to Claim 1,
**characterized in that**
the particles are ceramic particles.

3. Electronic device (16) according to Claim 2,
**characterized in that**
the ceramic particles are formed from silicon oxide, boron nitride or aluminium oxide or a combination thereof.

4. Electronic device (16) according to Claim 2,
**characterized in that**
the ceramic particles are formed from carbon particles, in particular carbon nanoparticles.

5. Electronic device (16) according to any of the preceding claims,
**characterized in that**
the particle proportion in the thermosetting plastic is between 50 and 80 per cent by weight of the thermally conductive wall region, wherein the particle-free remainder is formed by the thermosetting plastic as matrix material.

## Revendications

1. Dispositif électronique (16), notamment appareil de commande, comprenant boîtier (17, 18), le boîtier (17, 18) renfermant une cavité (24) et le dispositif (16) comportant un support de circuit (23) disposé dans la cavité (24), le support de circuit (23) comportant au moins un composant semi-conducteur (21), le dispositif (16) comportant un dissipateur thermique (19) qui est relié par conduction thermique au composant semi-conducteur (21), le boîtier (17, 24) étant un boîtier en matière synthétique et comportant une paroi de boîtier (18), au moins deux zones de paroi adjacentes (19, 20) étant formées dans la paroi de boîtier (18), et le dissipateur thermique (19) étant conçu comme une zone de paroi thermoconductrice (19) des zones de paroi (19, 20) du boîtier et au moins une autre zone de paroi (20) des zones de paroi (19, 20) présentant une conductivité thermique inférieure à celle de la zone de paroi thermoconductrice (19),
**caractérisé en ce que**
la zone de paroi thermoconductrice (19) est formée par une matière thermodurcissable chargée de particules qui est polymérisée au moyen de rayons ultraviolets (25).

2. Dispositif électronique (16) selon la revendication 1,
**caractérisé en ce que**
les particules sont des particules de céramique.

3. Dispositif électronique (16) selon la revendication 2,
**caractérisé en ce que**
les particules de céramique sont formées d'oxyde de silicium, de nitrure de bore ou d'oxyde d'aluminium ou d'une combinaison de ceux-ci.

4. Dispositif électronique (16) selon la revendication 2,
**caractérisé en ce que**
les particules de céramique sont formées de particules de carbone, notamment de nanoparticules de carbone.

5. Dispositif électronique (16) selon l'une des revendications précédentes,
**caractérisé en ce que**
la proportion de particules dans la matière thermodurcissable est comprise entre 50 et 80 pour cent en poids de la zone de paroi thermoconductrice, le reste sans particules étant formé comme matériau de matrice par la matière thermodurcissable.
